# EUROPEAN PATENT APPLICATION

(11) **EP 4 766 096 A1**
(43) Date of publication of application: **24.06.2026**
(21) Application number: 24221531.7
(22) Date of filing: 19.12.2024
(51) Int. Cl.: H10F 10/164, H10F 71/10, H10F 71/00, H10F 77/70

(54) **METHOD OF STRUCTURING AND DOPING OF POLYSILICON REGIONS FOR BACKSIDE CONTACT SOLAR CELL**

(71) Applicant: "International Solar Energy Research Center Konstanz", ISC Konstanz e.V., 78467 Konstanz (DE)
(72) Inventor: MIHAILETCHI, Dr. Valentin Dan, 78464 Konstanz (DE); KURUGANTI, Venkat Vaibhav, 78467 Konstanz (DE); BUCHHOLZ, Dr. Florian, 78462 Konstanz (DE)
(74) Representative: Westphal, Mussgnug & Partner Patentanwälte mbB

(57) **Abstract**

Provided is a method of structuring and doping of polysilicon regions for a backside contact solar cell, the method comprising the steps of: - providing a crystalline silicon substrate (100) having a front side (10) and a back side (11); -forming a SiO2 tunnel oxide layer (101) on the back side of the substrate (100); - forming a first amorphous silicon layer (102) on top of the tunnel oxide layer (101); - forming a doped SiO2 layer (103) that is doped with a first dopant belonging to a first dopant type on top of the first amorphous silicon layer (102); - forming a second amorphous silicon layer (105) that is located directly or indirectly over the doped SiO2 layer (103); - removing the second amorphous silicon layer (105) in a continuous portion of the back side (11) - etching the doped SiO2 layer (103) in the continuous portion of the back side (11) in which the second amorphous silicon layer (105) has been removed to expose a portion of the first amorphous silicon layer (102); - annealing and doping of the exposed portion of the first amorphous silicon layer (102) by diffusing a second dopant belonging to a second dopant type that is different from the first dopant type from a dopant source and simultaneously driving the first dopant from the doped SiO2 layer (103) into the unexposed portion of the first amorphous silicon layer (102) so that a transformation of the first and second amorphous silicon layer (102,105) to a first and second polysilicon layer (102,105) occurs and so that the first dopant type region and the second dopant-type region in the first polysilicon layer (102) form a junction between these dopant types of the solar cell; - removing the remaining parts of second polysilicon layer (105) and thinning the first polysilicon layer (102).

## Description

The present invention relates to the fabrication of a back contact solar cells with doped polysilicon junctions, and more particularly to a method of doping and structuring of polysilicon regions that substantially simplify the fabrication process and reduce costs.

A back contact solar cell refers to a cell that has the p-type and the n-type regions coupled to the metal contacts located on the back side of the cell. The most efficient back contact solar cells have the interdigitated p-type and the n-type regions formed by doped polysilicon layers on top of a thin tunnel silicon dioxide layer, forming the so called Tunnel Oxide Passivated Contact (TOPCon).

There are many ways to structure and form doped polysilicon regions for back contact silicon solar cells (hereafter TBC) applications. The existing methods for manufacturing TBC solar cells with polysilicon regions are complex, with tedious process steps, as they require multiple masking and etching steps to structure the polysilicon. Although currently available TBC solar cells are very efficient, even more efficient solar cells with simple and cost-effective manufacturing methods are required to meet future demands of renewable energy sources.

For example, in the SunPower patent US7468485 B1, the formation of the polysilicon p- and n-doped regions for a TBC solar cell was achieved by directly structuring a doped and an undoped silicon dioxide layer stack over the undoped polysilicon, without the need of a capping layer as a patterning layer. The structuring of the silicon dioxide layers involves for example photolithographic steps or local chemical etching by screen printing a hydrofluoric acid (HF) containing paste.

In the Longi patent application EP4386867A1, a first dielectric mask layer is used for structuring of a first doped polysilicon layer following by local removing the first doped layer over the second doped region and forming a second doped polysilicon layer over the first mask layer and the second doped region. In a subsequent step a second mask layer is formed over the second doped polysilicon region.

Similarly, in the Golden Solar patent application EP4354515A1, two masking steps and two doped polysilicon layers are sequentially formed in order to realize an alternated p-type and n-type polysilicon doped regions on the back side of the cell.

Such structuring methods rely on complete etching of the main polysilicon layer and then re-deposition for the opposite polarity doping, which is cost intensive in a mass-production of silicon solar cells and increase process complexity.

In another example, LG patent US10566488 B2, a method to form interdigitated polysilicon p-type and n-type doped regions is presented in which the doped polysilicon layers are formed first by a masked ion implantation of dopant into an intrinsic polysilicon layer to form the emitter regions and a subsequent second patterning step of a dielectric blocking layer to form the back surface field. The resulted solar cell has the interdigitated p-type and n-type doped polysilicon regions separated by an intrinsic polysilicon region that prevents shunting. However, the use of ion implantation in mass-production of solar cells was proven to be cost-intensive and complex, and this technology was eventually not adopted by the industry.

In yet another example, which is described e.g. by Samuel Harrisona et al. in the publication "Back contact heterojunction solar cells patterned by laser ablation", Energy Procedia 92 (2016) 730 - 737, a method of forming interdigitated doped a-Si layers on an IBC solar cell by laser structuring of a sacrificial a-Si capping layer was demonstrated. In this process route, a sequential deposition of multilayer stack consisting of a first intrinsic or doped a-Si layer, a silicon dioxide buffer layer, and a second thin intrinsic or doped a-Si masking layer was employed to form the interdigitated p-type and n-type regions. The second (masking) a-Si layer was then laser patterned and the first (main) a-Si layer beneath the laser ablated area was completely etched and re-deposited in a separate process step to form the opposite polarity regions. The complete etching of the first a-Si layer significantly increasing process complexity and costs of the solar cell device.

Accordingly, the problem to be solved by the invention is providing a more simple and cost-effective manufacturing method for highly efficient solar cells. This problem is solved by a method with the features of claim 1. Advantageous embodiments of the method can be obtained by implementing the additional optional features of the dependent claims.

The method of structuring and doping of polysilicon regions for backside contact solar cells according to the invention comprises the following steps that are preferably executed in the order in which they are mentioned:
- providing a crystalline silicon substrate having a front side and a back side. The front side is typically the side that is intended to face the sun when the backside contact solar cell is installed for application; the back side is the side opposite to the front side.
- forming a SiO2 tunnel oxide layer on the back side of the substrate.
- forming a first amorphous silicon layer on top of the tunnel oxide layer. It should be noted already at this point of time that during the process, especially during an annealing step that is described below, amorphous silicon layers are transformed into polysilicon layers. Therefore, during the production process (mostly) amorphous silicon layers are formed, whereas in the solar cell these amorphous silicon layers, or more precisely those parts of these layers that have not been removed, correspond to polysilicon layers to which they have been transformed.
- forming a doped SiO2 layer that is doped with a first dopant belonging to a first dopant type on top of the amorphous silicon layer. As well known in the art, there are two applicable dopant types, namely p-dopants and n-dopants. The most commonly used dopant belonging to the p-dopants is Boron, whereas the most commonly used dopant belonging to the n-dopants is Phosphorus, but other p-dopants or n-dopants may also be used. The dopant concentration of this doped SiO2 layer should be at least 0.5 wt.%
- forming a second amorphous silicon layer that is located directly or indirectly over the doped SiO2 layer.

It should be noted that due to the fact that the above layers can typically be formed on or over the entire respective substrate surfaces, evidently no major efforts are needed to guarantee proper alignment and no masking is required until this part of the method is completed.

With respect to terminology, according to this disclosure if a layer A is located on top of a layer B, layer A is formed directly over layer B. Accordingly, layer A is located directly over layer B and there is a direct contact between these layers (which may result in an automated formation of a transition region between these layers, which therefore may still be present when layer A is formed on top of layer B).

In contrast to that, if a layer A is formed over a layer B, this includes a situation where layer A is located on top of layer B as well as situations in which there may be one or more layers C, D,... between layer A and layer B that are created in additional processing steps, leading to a situation in which layer A is located indirectly over layer B. Specifically, as explained below in more detail, this wording allows for the forming of an optional additional, preferably undoped SiO2 layer between the doped SiO2 layer and the second amorphous silicon layer.

All of the layers that are described in the above processing steps can be formed using known techniques like PVD (Physical Vapour Deposition), PECVD (plasma-enhanced chemical vapour deposition), APCVD (atmospheric pressure chemical vapour deposition) or LPCVD (low pressure chemical vapour deposition).

Also, it should be noted that these steps can optionally be performed in the same processing environment without transporting the waver in between.

After these steps have been completed, according to the invention the steps of
- removing the second amorphous silicon layer in a continuous portion of the back side; and
- etching the doped SiO2 layer in the continuous portion of the back side in which the second amorphous silicon layer has been removed to expose a portion of the first amorphous silicon layer;
are performed.

The second amorphous silicon layer forms a capping layer or sacrificial layer for structuring, whereas the first amorphous silicon layer is the main layer intended to be doped that is transformed into a polysilicon layer and used in the device. The doped SiO2 layer that is arranged between them serves in the concept underlying the present invention as a dopant source for doping of those areas of the back side on which it remains in place. By the above-described method steps, it becomes possible to remove the doped SiO2 layer selectively with high precision and effectively in those continuous portions of the back side, where the second amorphous silicon layer is removed. The removal of the second amorphous silicon layer can, e.g., be done with high spatial precision with a laser, as described below in more detail.

Naturally, in order to etch the doped SiO2 layer in configurations in which a further layer of material is deposited between the doped SiO2 layer and the second amorphous silicon layer, this further layer has to be removed as well, which may be done e.g. in an etching step, as described below in more detail.

In this way, a configuration is achieved in which during a subsequent step of
- annealing and doping of the exposed portion of the first amorphous silicon layer by diffusing a second dopant belonging to a second dopant type that is different from the first dopant type from a dopant source and simultaneously driving the first dopant from the doped SiO2 layer -more precisely, the remaining part thereof- into the unexposed portion -i.e. the part that is still covered by the doped SiO2 layer- of the first amorphous silicon layer.

This leads to a situation in which a transformation of the first and second amorphous silicon layer to a first and second polysilicon layer occurs due to the annealing and the first dopant type region and the second dopant-type region in the resulting first polysilicon layer are created to form a junction between these dopant types of the solar cell to be produced. The doping of both dopant types is performed essentially simultaneously in their respective target regions. This eliminates numerous problems regarding alignment and dopant atom distribution in the doped regions that one encounters frequently when the doping is done subsequently.

Once the desired annealing and doping has been achieved, a step of
- removing the remaining parts of second polysilicon layer and thinning the first polysilicon layer (which have been created from the second amorphous silicon layer and the first amorphous silicon layer during the annealing) is performed, followed by
- removing the remaining parts of the doped SiO2 layer. Naturally, in order to do so, if additional layers are present between the doped SiO2 layer and the second amorphous silicon layer, they, too, are removed.

These steps ready the back side of the solar cell for additional processing steps during completion of the fabrication of the solar cell.

According to a preferred embodiment of the method, the thinning of the first polysilicon layer at least in the exposed portion that was annealed and doped with the second dopant belonging to the second dopant type leaves at least 10 nm of the first polysilicon layer remaining on said region of the back side of the silicon substrate. This remaining part of the first polysilicon layer serves the purpose of forming the second polysilicon region of opposite doping, thus completing the interdigitated structure of the TBC solar cell without the need of a re-deposition step. In this way, it is achieved that there is no need of additional deposition (or re-deposition) of the tunnel oxide and polysilicon layer doped with opposite polarity (in order to form the interdigitated polysilicon regions on the back side). This will save cost with the deposition steps as well as etching steps needed in this case to remove (structure) the polysilicon layer over the areas on the device where this re-deposited polysilicon layer is not needed. In addition, avoiding the re-deposition step may also have a benefit effect on cell performance.

According to another preferred version of the method, the second amorphous silicon layer is located indirectly over the doped SiO2 layer, an additional, preferably undoped, SiO2 layer is formed on top of the doped SiO2 layer and the second amorphous silicon layer is formed on top of the additional, preferably undoped SiO2 layer. Preferably, the additional, preferably undoped SiO2 layer is deposited to a thickness of 150 nm or less.

The inventors have found that this additional, preferably undoped SiO2 layer can lead to improved properties of the region that is doped with the first dopant atoms that are comprised in the doped SiO2 layer, possibly due to the fact that it reduces contamination of this layer with the second dopant atoms.

In order to expose a portion of the first amorphous silicon layer if an additional, preferably undoped SiO2 layer is deposited on top of the doped SiO2 layer, preferably the additional, preferably undoped SiO2 layer is etched in the continuous portion of the back side in which the second amorphous silicon layer has been removed prior to the etching the doped SiO2 layer in the continuous portion of the back side in which the second amorphous silicon layer has been removed to expose a portion of the first amorphous silicon layer. This can be done in the same etching process.

Preferably, the SiO2 tunnel oxide layer, first amorphous silicon layer, the doped SiO2 layer and the second amorphous silicon layer are deposited in-situ in the same process tool by PVD, PECVD, APCVD, or LPCVD in order to increase the overall efficiency of the production process.

The first amorphous silicon layer can be intrinsic or lightly doped. The advantage of an intrinsic first amorphous silicon layer is the prevention of doping contamination and shunting of the cell. However, in the case of PVD deposition technique, a lightly doped polysilicon with a dopant concentration below 1e17 cm⁻³ allows to benefit from direct current (DC) magnetron sputtering technique. The DC sputtering offers significant higher deposition rates and is an industrial relevant technique for mass-production.

If boron is to be used as the first dopant, preferably the doped SiO2 layer comprises a B2O3 layer or a B2O3:SiO2 glass layer having a boron content of at least 0,5 wt.%. In this situation, if phosphorus is used as the second dopant, preferably the annealing of the first amorphous silicon layer is performed in-situ in a phosphorus diffusion furnace at different temperature or simultaneously during the doping phase.

Conversely, if phosphorous is to be used as the first dopant, the doped SiO2 layer preferably comprises a P2O5 layer or a P2O5:SiO2 glass layer having a phosphorus content of at least 0,5 wt.%. In this situation, if boron is used as the second dopant, preferably the annealing of the first amorphous silicon layer is performed in-situ in a boron diffusion furnace at different temperature or simultaneously during the doping phase.

A preferred variant of the method can be used In order to realize a high efficiency shunt free IBC solar cell in which the doped poly-Si(n+) and poly-Si(p+) regions are separated by a passivated crystalline Si (c-Si) trench region that could be either doped or undoped. In order to achieve this, wherein between the steps of
- removing the second amorphous silicon layer in a continuous portion of the back side and
- etching the doped SiO2 layer in the continuous portion of the back side in which the second amorphous silicon layer has been removed to expose a portion of the first amorphous silicon layer,
the additional step of laser doping and epitaxial recrystallization of an amorphous silicon region to form a p+ doped crystalline silicon region in a portion where the second amorphous silicon layer is removed is performed. Furthermore, during the etching of the doped SiO2 layer to expose a portion of the first amorphous silicon layer the doped region is also exposed.

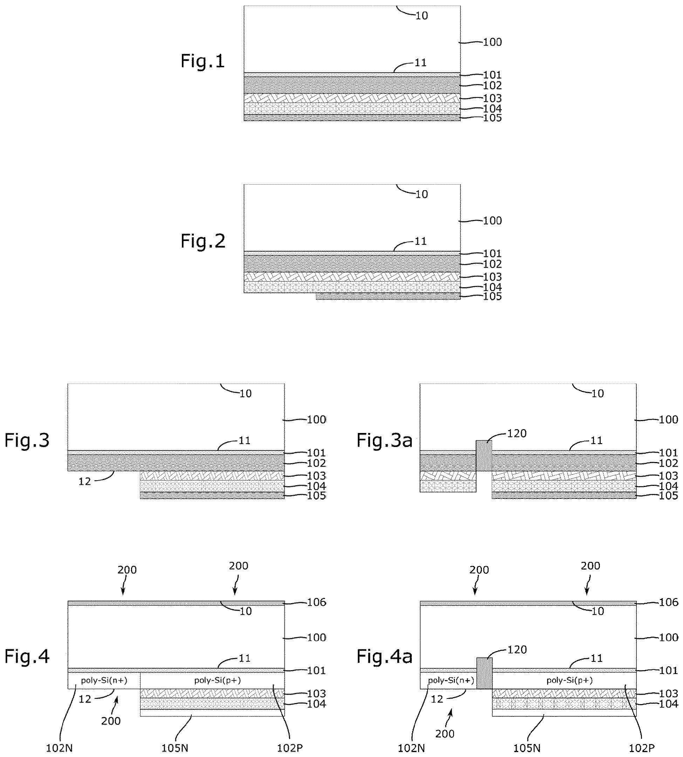

An embodiment of the method is illustrated in **Figs. 1-9****.** The process starts with a saw-damage etch and cleaning of a silicon substrate **100 (****Fig. 1****)** to provide the crystalline silicon substrate having a front side 10 and a back side 11. The substrate **100** may be an n-type doped monocrystalline silicon wafer, for example.

A tunnel SiO₂ layer **101** is formed on the backside **11** of the silicon wafer with a thickness preferably between 0.5 nm and 3 nm.

A first intrinsic amorphous silicon (furtheron referred to as a-Si), a-Si(i), layer **102** is deposited on the SiO₂ layer **101** to a thickness preferably between 50 um to 300 um. Alternatively a-Si layer **102** can be lightly doped, e.g. boron doped a-Si(p), as long as its active concentration, e.g. its active boron concentration, in the annealed polysilicon layer is less than 1e17 cm⁻³.

In this context, it should be noted that strictly speaking, the layer 102 is an amorphous Si layer after deposition, which changes its composition during the process leading to the formation of the solar cell. During an annealing step, in this example after a POCl3 diffusion step, the a-Si layers, e.g. layer 102, turn into polysilicon (polySi) layers 102, which are present in the final solar cell. As a matter of fact, if LPCVD is used to deposit the a-Si layer, it may already be partly crystallized after deposition.

A boron doped SiO₂ layer **103** and an additional, preferably undoped SiO2 layer **104** are deposited over the a-Si(i) layer 102. The SiO₂ layer **103** is heavily p-type (boron) doped in this example, such as a borosilicate glass (BSG) layer, and serves as a dopant source for the subsequent doping of the a-Si layer **102.** Such BSG layer can be formed for example by PVD sputter process from a target containing B2O3 or co-sputtered from a Boron and a Si or SiO2 target. It can also be formed by APCVD or PECVD deposition from a B2H4 gas precursor. A preferred BSG thickness range is between 20-80 nm whereas the additional, preferably undoped SiO2 layer **104** is deposited to a thickness preferable between 20-160 nm.

The process is continued by the deposition of a second a-Si layer **105** that will serve as a thin capping layer over the BSG/SiO2 layers **103/104** for the subsequent laser patterning step. This a-Si capping layer can be either intrinsic or doped, such as the layer **104,** and is deposited to a preferred thickness range between 5-50 nm.

The deposition and formation of the stack layers **101-105 (****Fig. 1****)** can be conveniently performed in-situ in the same process tool, such as PVD, PECVD, or APCVD, thus further reducing process complexity and costs.

In a subsequent fabrication step of the solar cells, the a-Si capping layer **105** is partially removed, conveniently by laser ablation process **(****Fig. 2****),** and the underlying SiO2 layers **103/104** are then etched in a diluted HF solution in order to expose the region **12** of the a-Si layer **102** under the laser ablation area **(****Fig. 3****).** Preferably, the laser ablation of the capping layer **105** should be performed softly, at relative low laser fluence, in order to prevent damaging the underlying a-Si layer **102.** For this reason the thin a-Si capping layer **105** is preferred, due to its high absorption coefficient, over other capping layers commonly used in industry such as PECVD SiNx.

In the next process step the wafers are loaded into a phosphorus diffusion furnace for an in-situ annealing and diffusion process **200,** in order to crystallize the a-Si layers **102** and **105** and n+ doping of the poly-Si layer **102** under the region **12,** thereby forming the n+ poly-Si layers **102N** and **105N** as well as a n+ doped crystalline Si region **106** on the front surface (region **10)** of the wafer.

During this annealing and doping step the p+ doped poly-Si layer **102P** will also be formed by driving-in the dopant from the doped SiO2 layer **103 (****Fig. 4****).**

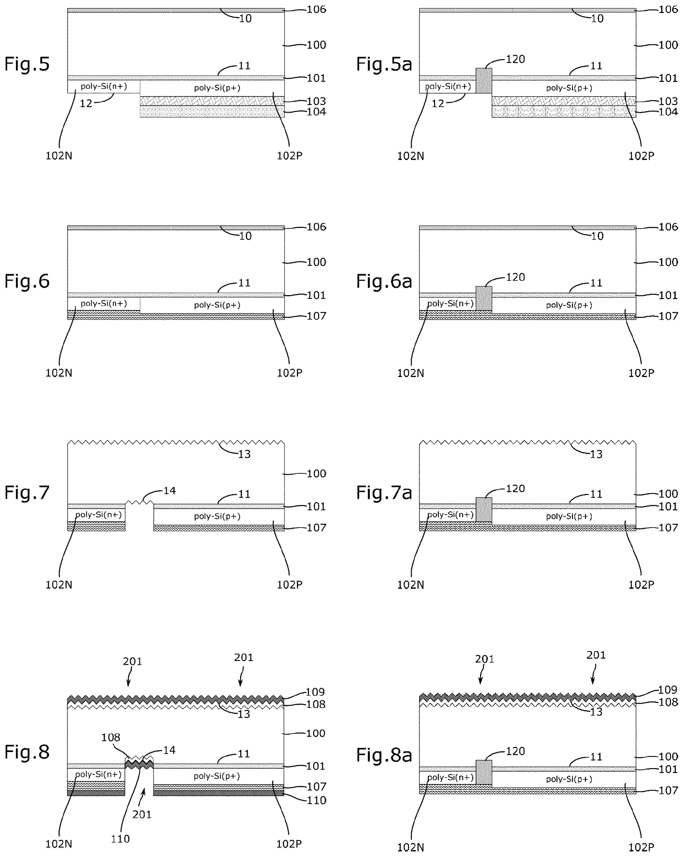

In the next process step the thin poly-Si capping layer **105N** is controllably etched whereas the thicker layer **102N** is only thinned, but not completely etched, before the etching process is stopped **(****Fig. 5****).** The etching of the capping layer **105N** can be conveniently performed in an alkaline solution or by atmospheric dry etching using a F2 gas.

The remaining SiO2 layers **103** and **104** are then etched in the HF solution and the formation of interdigitated n+ and p+ doped poly-Si regions **102N** and **102P** are realized on the rear surface **11** of the IBC cells.

In another embodiment the doped SiO2 layer **103** can be phosphorous doped, such as a phosphosilicate glass (PSG) layer, and the annealing and doping process step **200** is performed in a boron diffusion furnace, resulting in a poly-Si(p+) region under the laser ablation region **12** and a poly-Si(n+) region elsewhere.

In order to realize a high efficiency shunt free IBC solar cell, the doped poly-Si(n+) and poly-Si(p+) regions **102N** and **102P** should be separated by a passivated crystalline Si (c-Si) trench region that could be either doped or undoped.

Returning to the example of the first embodiment, , in this example the passivated trench regions are realized by the following process steps shown in **Figs. 6-8****.**

In this context, it should be noted that the trench region formed in Figs. 6-8 does not necessary need be made only over the poly-Si(n+) region or only over the poly-Si(p+) region, but the laser ablation region to form the trench could also be over both regions in any fraction. Important, is here that the trench is not located only over one of the regions (e.g. poly-Si(n+) or poly-Si(p+)) such that it still leaves an area where the poly-Si(n+) and poly-Si(p+) regions can get into contact (in this case the cell would be shunted). So the trench is there to physically separate the two regions but it does not matter whether it is formed by consuming one or the other doped poly-Si regions.

First, a dielectric masking layer **107,** preferably a SiNx layer, is deposited on the rear surface **11** by PECVD to a thickness range of 20-80 nm **(****Fig. 6****).** The masking layer **107** is then locally opened over the entire length of the n+/p+ poly-Si junction region by means of laser ablation. The resulted exposed Si surface is etched in alkaline texture solution to form a textured trench region **14** between n+ and p+ doped poly-Si regions on the back side and a texture region **13** on the front side of the wafer **(****Fig. 7****).**

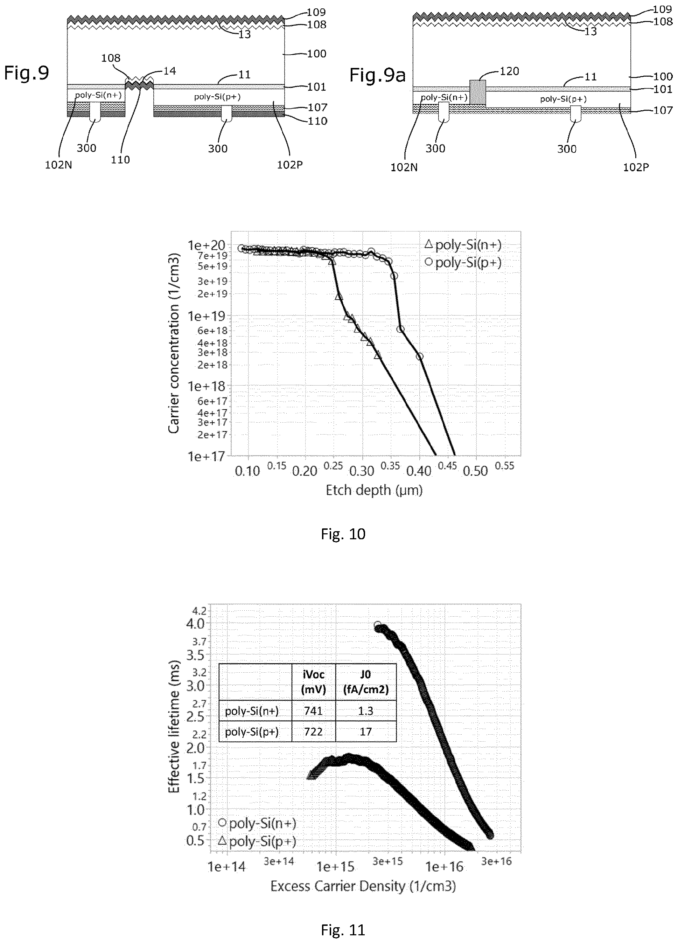

I a subsequent process step the regions **13** and **14** are boron doped in a diffusion furnace containing a boron gas precursor, resulting in the p+ doped c-Si region **108** on the back side trench regions as well as on the front side of the wafer. A passivating SiNx layer, or layers stack comprising of SiO2/SiNx or AlOx/SiNy, is deposited by PECVD on the p+ c-Si front and back side regions of the solar cell **(****Fig. 8****).** The solar cell process is then completed by applying a screen printed metallization step **300 (****Fig. 9****).**

In yet another embodiment of this invention, the passivated trench regions between the doped poly-Si(n+) and poly-Si(p+) regions **102N** and **102P** are realized by laser doping of crystalline Si bulk in a portion beneath the poly-Si(p+) region at the poly-Si(n+)/poly-Si(p+) interface and solid phase epitaxial recrystallization of the poly-Si(p+) layer **(****Figs. 3a-9a****).**

This can be realized in the same process step during the patterning of the a-Si capping layer **105.** For example after the removal of a-Si capping layer **105 (****Fig. 2****)** at relatively low laser fluence of less than 2 J/cm2, the laser fluence is increased above 3 J/cm2 up to the point where the bulk crystalline Si region **120** is p+ doped and the poly-Si(p+) layer is epitaxial recrystallized **(****Fig. 3a****).**

In the following process step the SiO2 layers **103** and **104** that have been made accessible by removal of the second poly-Si layer **105** in the region **12** are etched and the wafers are loaded into a phosphorus diffusion furnace for an in-situ annealing and diffusion process **200,** in order to crystallize the a-Si layers **102** and **105** and n+ doping of the poly-Si layer **102** under the region **12,** thereby forming the n+ poly-Si layers **102N** and **105N** as well as a n+ doped crystalline Si region **106** on the front surface (region **10)** of the wafer.

In the next process step the thin capping layer **105N** is controllably etched whereas the thicker layer **102N** and the p+ doped crystalline region **120** are only thinned, but not completely etched, before the etching process is stopped **(****Fig. 5a****).** The remaining SiO2 layers **103** and **104** are then etched in the HF solution and the formation of interdigitated n+ and p+ doped poly-Si regions **102N** and **102P** separated by a p+ doped crystalline Si region are then realized on the rear surface **11** of the IBC cells **(****Fig. 6a****).**

In one exemplary way to complete the solar cells fabrication, a dielectric masking layer **107,** preferably a SiNx layer, is deposited on the back surface **11** by PECVD to a thickness range of 20-80 nm **(****Fig. 6a****).** The exposed Si surface on the front side is then etched in alkaline texture solution **(****Fig. 7a****).** In a subsequent process step the front region **13** is boron doped in a diffusion furnace containing a boron gas precursor, resulting in the p+ doped c-Si region **108** on the front side of the wafer. A passivating SiNx layer, or layers stack comprising of SiO2/SiNx or AlOx/SiNy, is deposited by PECVD on the p+ c-Si front side region of the solar cell **(****Fig. 8a****).** The solar cell process is then completed by applying a screen printed metallization step **300 (****Fig. 9a****).**

It is stressed that the above-described front side treatment is optional. The front side may be doped or not and/or passivated or not. Boron doping and passivation of the front side is one example here, but any other state-of-the-art method could be applied, i.e., a phosphorous doped or even undoped (intrinsic) front surface field could be made.

**Fig. 10** shows the doping profiles of the poly-Si(p+) and poly-Si(n+) regions, **102P** and **102N,** after the annealing and doping step **200 (****Fig. 4** and **Fig. 4a****)** in accordance with an embodiment of current invention. Both doped regions **102P** and **102N** indicate a good TOPCon structure.

**Fig. 11** shows the lifetime curves obtained by passivating **102P** and **102N** regions. The extracted implied open-circuit voltage (iVoc) and saturation current density (J0) of poly-Si(p+) and poly-Si(n+) layers are shown in the inset.

### Reference numerals

- 10 -: front surface of the silicon wafer
- 11 -: back surface of the silicon wafer
- 12 -: back surface field poly-Si region
- 13 -: textured front surface
- 14 -: textured back side trench region
- 100 -: n-type crystalline silicon substrate,
- 101 -: thin tunnel oxide,
- 102 -: first intrinsic or lightly p-type doped a-Si or poly-Si layer
- 102N -: n+ doped poly-Si region
- 102P -: p+ doped poly-Si region
- 103 -: B2O3:SiO2 (BSG) layer
- 104 -: undoped or lightly boron doped SiO2 layer
- 105 -: second intrinsic or lightly p-type doped a-Si or poly-Si masking layer
- 106 -: n+ doped c-Si region
- 107 -: dielectric masking layer (eg., SiNx)
- 108 -: p+ doped c-Si region
- 109 -: front side passivation layer
- 110 -: rear side passivation layer
- 120 -: p+ doped epitaxial recrystallized c-Si region
- 200 -: phosphorus diffusion
- 201 -: boron diffusion
- 300 -: metal contacts

## Claims

1. A method of structuring and doping of polysilicon regions for a backside contact solar cell, the method comprising the steps of:
- providing a crystalline silicon substrate (100) having a front side (10) and a back side (11);
- forming a SiO2 tunnel oxide layer (101) on the back side of the substrate (100);
- forming a first amorphous silicon layer (102) on top of the tunnel oxide layer (101);
- forming a doped SiO2 layer (103) that is doped with a first dopant belonging to a first dopant type on top of the first amorphous silicon layer (102);
- forming a second amorphous silicon layer (105) that is located directly or indirectly over the doped SiO2 layer (103);
- removing the second amorphous silicon layer (105) in a continuous portion of the back side (11)
- etching the doped SiO2 layer (103) in the continuous portion of the back side (11) in which the second amorphous silicon layer (105) has been removed to expose a portion of the first amorphous silicon layer (102);
- annealing and doping of the exposed portion of the first amorphous silicon layer (102) by diffusing a second dopant belonging to a second dopant type that is different from the first dopant type from a dopant source and simultaneously driving the first dopant from the doped SiO2 layer (103) into the unexposed portion of the first amorphous silicon layer (102) so that a transformation of the first and second amorphous silicon layer (102,105) to a first and second polysilicon layer (102,105) occurs and so that the first dopant type region and the second dopant-type region in the first polysilicon layer (102) form a junction between these dopant types of the solar cell;
- removing the remaining parts of second polysilicon layer (105) and thinning the first polysilicon layer (102) .

2. Method according to claim 1, wherein the thinning of the first polysilicon layer (102) at least in the exposed portion that was annealed and doped with the second dopant belonging to the second dopant type leaves at least 10 nm of the first polysilicon layer (102) remaining on said region of the back side (11) of the silicon substrate (100).

3. Method according to claim 1 or 2, wherein the second amorphoussilicon layer (105) is located indirectly over the doped SiO2 layer (103), wherein an additional, preferably undoped SiO2 layer (104) is formed on top of the doped SiO2 layer (103) and wherein the second amorphous silicon layer (105) is formed on top of the additional, preferably undoped SiO2 layer (104).

4. Method according to claim 3, wherein the additional, preferably undoped SiO2 layer (104) is deposited to a thickness of 150 nm or less.

5. Method according to one of claims 3 or 4, wherein the additional, preferably undoped SiO2 layer (104) is etched in the continuous portion of the back side (11) in which the second amorphous silicon layer (105) has been removed to expose a portion of the first amorphous silicon layer (102) prior to the etching the doped SiO2 layer (103) in the continuous portion of the back side (11) in which the second amorphous silicon layer (105) has been removed to expose a portion of the first amorphous silicon layer (102) .

6. Method according to one of claims 1 to 5, wherein the SiO2 tunnel oxide layer (101), first amorphous silicon layer (102), the p-type doped SiO2 layer (103) and the second amorphous silicon layer (105) are deposited in-situ in the same process tool by PVD, PECVD, APCVD, or LPCVD.

7. Method according to one of claims 1 to 6, wherein the first amorphous silicon layer (102) is intrinsic or lightly doped.

8. Method according to one of claims 1 to 7, wherein the doped SiO2 layer (103) comprises a B2O3 layer or a B2O3:SiO2 glass layer having a boron content of at least 0.5 wt.%.

9. Method according to claim 8, wherein the annealing of the first amorphous silicon layer (102) is performed in-situ in a phosphorus diffusion furnace at different temperature or simultaneously during the doping phase.

10. Method according to one of claims 1 to 7, wherein the doped SiO2 layer (103) comprises a P2O5 layer or a P2O5:SiO2 glass layer having a phosphorus content of at least 0.5 wt.%.

11. Method according to claim 10, wherein the annealing of the first amorphous silicon layer (102) is performed in-situ in a boron diffusion furnace at different temperature or simultaneously during doping phase.

12. Method according to one of claims claim 1 to 11, wherein between the steps of
- removing the second amorphous silicon layer (105) in a continuous portion of the back side (11) and
- etching the doped SiO2 layer (103) in the continuous portion of the back side (11) in which the second amorphous silicon layer 105 has been removed to expose a portion of the first amorphous silicon layer (102),
laser doping and epitaxial recrystallization of polysilicon region (102) to form a p+ doped crystalline Si region (120) in a portion where the amorphous silicon layer (105) is removed is performed; and
wherein during the etching of the doped SiO2 layer (103) to expose a portion of the first amorphous silicon layer (102) the doped region (120) is also exposed.
